# EUROPEAN PATENT SPECIFICATION

(11) **EP 3 621 204 B1**
(45) Date of publication and mention of the grant of the patent: **31.03.2021**
(21) Application number: 19195874.3
(22) Date of filing: 06.09.2019
(51) Int. Cl.: H03K 17/97

(54) **MAGNETIC KNOB CONTROL AND ELECTRICAL APPARATUS**
MAGNETISCHER KONTROLLKNOPF UND ELEKTRISCHES GERÄT
BOUTON DE CONTROLE MAGNÉTIQUE ET APPAREIL ELÉCTRIQUE

(30) Priority: 06.09.2018 CN 201811039334
(43) Date of publication of application: 11.03.2020
(73) Proprietor: Foshan Shunde Midea Washing Appliances Manufacturing Co., Ltd., Foshan, Guangdong 528311 (CN)
(72) Inventor: LIN, Hailong, Beijiao, Shunde, Foshan, Guangdong 528311 (CN); ZHANG, Bingwei, Beijiao, Shunde, Foshan, Guangdong 528311 (CN); XIE, Zhanghai, Beijiao, Shunde, Foshan, Guangdong 528311 (CN)
(74) Representative: RGTH

(56) References cited:
- EP-A1- 3 171 233
- CN-A- 107 147 386
- CN-Y- 201 407 713
- US-A1- 2011 096 008
- US-A1- 2012 326 817
- US-A1- 2017 052 633
- US-A1- 2018 174 786
- US-A1- 2018 196 518

## Description

### Cross-Reference to Related Applications

The present application claims for the benefits of the Chinese Patent Application No. 201811039334.4 filed on Sep. 6, 2018.

### Field of the Invention

The present invention belongs to field of home appliances, in particular to a magnetic control knob assembly and an electrical apparatus.

### Background of the Invention

In a conventional electrical apparatus such as a gas stove, usually through-hole is arranged in the casing of the electrical apparatus to connect knobs to control valves in the electrical apparatus. In order to avoid oil leakage into the electrical apparatus through the through-holes, which brings inconvenience to the cleaning and management work of the user, usually magnetic control knobs are used to control the electrical apparatus.

At present, magnetic control knobs only achieve a regulation and control function by rotation, but can't control the electrical apparatus by pressing. Thus, the magnetic control knobs have a relatively simple function and can't regulate and control the electrical apparatus satisfactorily. Therefore, it is an important task to develop a magnetic control knob that has a turning control function and a pressing control function.

CN 107 147 386 A discloses a press button with a top cover and a bottom cover. The top cover is connected with a magnetic induction line cutter and can be pressed against the bottom cover in order to disturb magnetic fields of a conductor magnetic field generator. The conductor magnetic field generator is arranged inside the bottom cover. Further state of the art is known from US 2011/396008 A1 and US 2018/196518 A1. CN 201 407 713 Y discloses a magnetic control knob assembly with a turning control function suitable for control of an electrical apparatus, wherein Hall sensors are fixedly arranged in an inner cavity of a casing of the electrical apparatus.

### Summary of the Invention

In view of the above-mentioned shortcomings or drawbacks in the prior art, an object of the present invention is to provide a magnetic control knob assembly and an electrical apparatus without the requirement of through-holes in a casing of the electrical apparatus and to provide an improved user experience. The magnetic control knob assembly can be used to control an electrical apparatus by pressing the magnetic control knob. Thus, the magnetic control knob has both turning control function and pressing control function, i.e., the functions are more diversified, which is favorable for improving user experience.

To attain the above-mentioned objects, the present invention provides a magnetic control knob assembly, which comprises a magnetic control knob and a conductor magnetic field generator arranged fixedly, wherein the magnetic control knob comprises a top cover and a bottom cover that are snap-fitted with each other, and the top cover is connected with a magnetic induction line cutter; wherein the top cover can be pressed to move toward the bottom cover, the magnetic induction line cutter cuts an electromagnetic field generated by the conductor magnetic field generator in the pressed movement process to change the inductance of energized conductors in the conductor magnetic field generator, wherein the conductor magnetic field generator is fixedly arranged in an inner cavity of a casing of the electrical apparatus, and the magnetic control knob is arranged on an outer surface of the casing and can rotate freely.

Wherein, a bearing plate may be arranged in an inner cavity of knob of the magnetic control knob in a way that the bearing plate is connected with the top cover and arranged horizontally, and the magnetic induction line cutter is a metal plate and superimposed on a surface of the bearing plate.

The distance between the bottom end of the magnetic induction line cutter and the top end of the energized conductors preferably is not greater than 10mm.

The magnetic control knob comprises an internal supporting member disposed above the bearing plate and fixedly arranged in the inner cavity of knob horizontally, and an elastic resetting member for resetting by pressing is arranged between the top surface of the internal supporting member and the bottom surface of the top cover.

A plurality of connecting columns are arranged in the circumferential direction in a spaced form on the bottom surface of the top cover, and the bottom ends of the connecting columns penetrate through the internal supporting member downward from above and are snap-fitted to the bearing plate; a plurality of abutting columns extend in the circumferential direction in a spaced form from the bottom surface of the internal supporting member, and the top surface of the bearing plate abuts against the bottom surfaces of the abutting columns.

The elastic resetting member preferably is an annular silicone pad abutting against the top surface of the internal supporting member and the bottom surface of the top cover respectively, and a plurality of upwardly recessed elastic resetting grooves are arranged in the circumferential direction in a spaced form in the bottom surface of the annular silicone pad.

The maximum distance of the pressed movement of the top cover toward the bottom cover preferably is not smaller than 0.8mm and not greater than 2.5mm.

The conductor magnetic field generator may comprise a capacitor and a solenoid formed by an energized conductor wound in multiple layers, the two ends of the solenoid are connected with the two ends of the capacitor through a first electrical connecting wire and a second electrical connecting wire, and a resonant frequency detector is arranged between the first electrical connecting wire and the second electrical connecting wire; wherein, the magnetic control knob assembly comprises a controller configured to: receive a resonant frequency signal from the resonant frequency detector; calculate the distance of movement of the magnetic induction line cutter toward the solenoid according to the resonant frequency signal; and trigger a control signal for the electrical apparatus if the distance of movement is greater than a preset distance.

The control signal may be a device startup signal, device shutdown signal, or device operation acknowledgement signal.

The conductor magnetic field generator may comprise a solenoid formed by an energized conductor wound in multiple layers, and the magnetic control knob assembly comprises an inductance detector configured to detect the inductance of the solenoid and a controller; wherein, the controller is configured to: receive an inductance signal from the inductance detector; calculate the distance of movement of the magnetic induction line cutter toward the solenoid according to the inductance signal; and trigger a control signal for the electrical apparatus if the distance of movement is greater than a preset distance.

The magnetic control knob assembly may comprise a fixed positioning magnet arranged in a fixed manner, and the conductor magnetic field generator comprises a plurality of solenoids, each of which is formed by an energized conductor wound in multiple layers, and the plurality of solenoids are arranged around the fixed positioning magnet; and/or a knob positioning magnet fitted with the fixed positioning magnet is arranged at the center of the top surface of the bottom cover.

The present invention further provides an electrical apparatus, which comprises a casing and a magnetic control knob assembly, wherein, the conductor magnetic field generator is fixedly arranged in the inner cavity of the casing, and the magnetic control knob is arranged on the outer surface of the casing and can rotate freely.

The electrical apparatus may be a gas stove, baking oven, electromagnetic oven, microwave oven, or kitchen hood.

With the above technical scheme, in the present invention, the top cover and the bottom cover are snap-fitted with each other, and the energized conductors in the conductor magnetic field generator can generate an electromagnetic field; when the top cover is pressed to move toward the bottom cover, the magnetic induction line cutter connected with the top cover is driven to move toward the bottom cover too, so that the magnetic induction line cutter cuts the electromagnetic field and thereby changes the magnetic flux of the energized conductors, so that the inductance of the energized conductors is changed. In that way, the change of the distance between the magnetic induction line cutter and the energized conductors can be ascertained by detecting and analyzing the inductance of the energized conductors or other parameters (e.g., resonant frequency, etc.) induced by the inductance of the energized conductors, and thereby a signal can be triggered to control the electrical apparatus. In that way, the magnetic control knob has both turning control function and pressing control function, i.e., the functions are more diversified, which is favorable for user operation and thereby can greatly improve user experience improvement.

Other features and advantages of the present invention will be further detailed in the embodiments hereunder.

### Brief Description of Drawings

The accompanying drawings, which constitute a part of the present invention, are provided to facilitate further understanding the present invention; the illustrative embodiments and associated description in the present invention are provided to explain the present invention, and shall not be deemed as constituting any undue limitation to the present invention. In the figures:
Fig. 1 is a schematic structural diagram of the magnetic control knob assembly according to an embodiment of the present invention;
Fig. 2 is a front view of the magnetic control knob in Fig. 1;
Fig. 3 is a sectional view of the entire structure in Fig. 2;
Fig. 4 is an exploded view of the structure in Fig. 2;
Fig. 5 is a bottom view of the metal plate superimposed on the bottom surface of the bearing plate in Fig. 3;
Fig. 6 is a bottom view of the annular silicone pad in Fig. 3; and

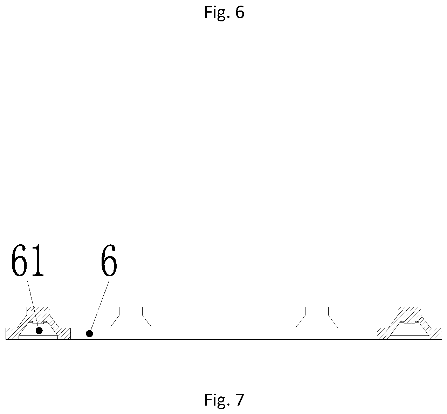

Fig. 7 is a sectional view of the entire structure in Fig. 6.

### Reference Numbers:

| | | | |
|---|---|---|---|
| 100 | Magnetic control knob | | |
| 300 | Casing | | |
| 201 | Solenoid | 202 | Fixed positioning magnet |
| 1 | Top cover Magnetic induction line | 2 | Bottom cover |
| 3 | cutter | 4 | Bearing plate |
| 5 | Internal supporting member | 6 | Annular silicone pad |
| 7 | Connecting column | 8 | Knob positioning magnet |
| 51 | Abutting column | 61 | Elastic resetting groove |
| X | Inner cavity of knob | | |

### Detailed Description of the Embodiments

Hereunder some embodiments of the present invention will be detailed with reference to the accompanying drawings. It should be understood that the embodiments described here are only provided to describe and explain the present invention rather than constitute any limitation to the present invention.

It should be noted that the embodiments and the features in the embodiments can be combined freely, provided that there is no confliction among them.

In the present invention, unless otherwise specified, the words that denote directions or orientations, such as "above", "below", "top", and "bottom", etc., are usually used to describe the relative position relations among the components with respect to the direction shown in the accompanying drawings or the vertical, plumb, or gravity direction.

Hereunder the present invention will be detailed in embodiments with reference to the accompanying drawings.

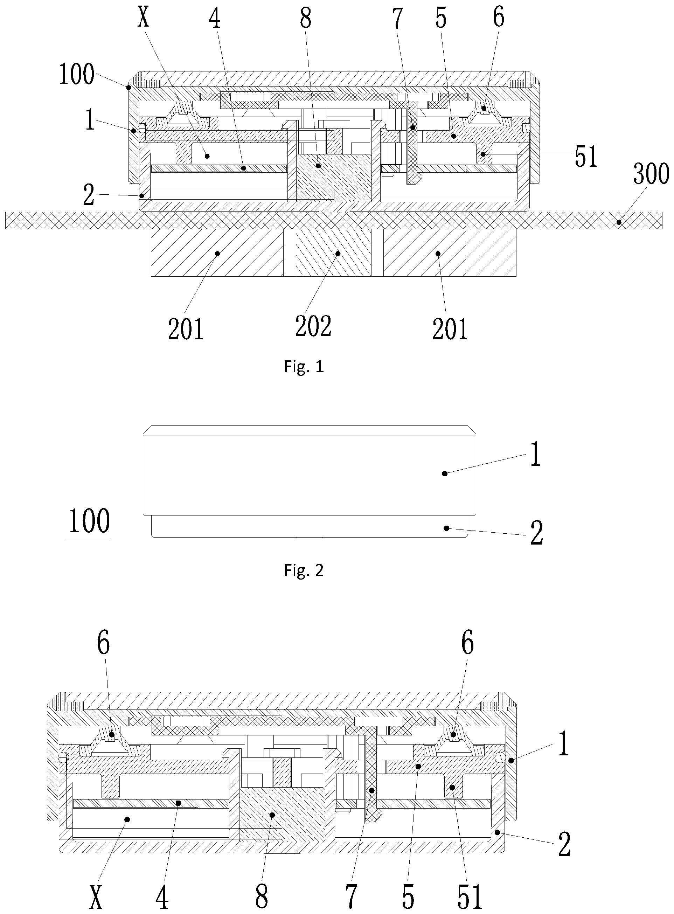

In a first aspect, the present invention provides a magnetic control knob assembly. As shown in Fig. 1, the magnetic control knob assembly is applied in an electrical apparatus and comprises a magnetic control knob 100 and a conductor magnetic field generator arranged fixedly, wherein the magnetic control knob 100 comprises a top cover 1 and a bottom cover 2 that are snap-fitted with each other, and the top cover 1 is connected with a magnetic induction line cutter 3; wherein the top cover 1 can be pressed to move toward the bottom cover 2, the magnetic induction line cutter 3 cuts an electromagnetic field generated by the conductor magnetic field generator in the pressed movement process to change the inductance of energized conductors in the conductor magnetic field generator.

Accordingly, the present invention further provides an electrical apparatus, which comprises a casing 300 and a magnetic control knob assembly, wherein, the conductor magnetic field generator is fixedly arranged in the inner cavity of the casing, and the magnetic control knob 100 is arranged on the outer surface of the casing 300 and can move freely. Wherein, the electrical apparatus may be a separate electrical apparatus, such as gas stove, baking oven, electromagnetic oven, microwave oven, or kitchen hood, etc.; of course, alternatively the electrical apparatus may be an integrated electrical apparatus, such as an integrated gas stove that integrates a gas stove and a baking oven, etc.

In the present invention, when the user presses the top cover 1 of the magnetic control knob 100, the top cover 1 will move toward the bottom cover 2, and thereby drive the magnetic induction line cutter 3 connected with the top cover 1 to move toward the bottom cover 2 too; in addition, the energized conductors in the conductor magnetic field generator can generate an electromagnetic field. Thus, when the magnetic induction line cutter 3 moves toward the bottom cover 2, the distance between the magnetic induction line cutter 3 and the fixedly arranged energized conductors is changed, and thereby eddy current is formed in the magnetic induction line cutter 3, so that the magnetic flux of the energized conductors is changed, and thereby the inductance of the energized conductors is changed. The change of the distance between the magnetic induction line cutter 3 and the energized conductors can be ascertained by detecting the inductance of the energized conductors or other parameters (e.g., resonant frequency described below, etc.) induced by the inductance of the energized conductors and then analyzing the detected parameter values, and thereby a signal can be triggered to control the electrical apparatus.

Particularly, the present invention innovatively employs a pressing means to enable the magnetic induction line cutter 3 to cut the electromagnetic field generated by the conductor magnetic field generator, and thereby the inductance of the energized conductors in the conductor magnetic field generator is changed, so that the electrical apparatus can be controlled. Thus, the magnetic control knob 100 not only has a turning control function, but also has a pressing control function. Therefore, the functions of the magnetic control knob 100 are more diversified, which is favorable for user operation and can greatly improve user experience.

The conductor magnetic field generator may comprise a capacitor and a solenoid 201 formed by an energized conductor wound in multiple layers, the two ends of the solenoid 201 are connected with the two ends of the capacitor through a first electrical connecting wire and a second electrical connecting wire, and a resonant frequency detector is arranged between the first electrical connecting wire and the second electrical connecting wire; wherein, the magnetic control knob assembly comprises a controller configured to: receive a resonant frequency signal from the resonant frequency detector; calculate the distance of movement of the magnetic induction line cutter 3 toward the solenoid 201 according to the resonant frequency signal; and trigger a control signal for the electrical apparatus if the distance is greater than a preset distance.

Moreover, there are a variety of ways to cause the inductance of the energized conductors in the conductor magnetic field generator to change by pressing the top cover 1 of the magnetic control knob 100 and thereby enable control of the electrical apparatus. For example, the conductor magnetic field generator comprises a solenoid 201 formed by an energized conductor wound in multiple layers, and the magnetic control knob assembly comprises an inductance detector configured to detect the inductance of the solenoid 201 and a controller; wherein, the controller is configured to: receive an inductance signal from the inductance detector; calculate the distance of movement of the magnetic induction line cutter 3 toward the solenoid 201 according to the inductance signal; and trigger a control signal for the electrical apparatus if the distance of movement is greater than a preset distance. Of course, the distance of movement of the magnetic induction line cutter 3 toward the solenoid 201 may be ascertained by analyzing the inductance of the energized conductor in other proper ways, which are not enumerated one by one here.

Wherein, the control signal may be a control signal, such as device startup signal, device shutdown signal, or device operation acknowledgement signal, or the like. Specifically, in a case that the control signal is a device startup signal or device shutdown signal, the user may start up or shut down the electrical apparatus simply by pressing the top cover 1 of the magnetic control knob 100; in the case that the control signal is a device operation confirmation signal, an operating mode (e.g., low flame mode of gas stove) or parameter (e.g., baking temperature of baking oven) of the electrical apparatus may be confirmed. Hereunder the device operation confirmation signal will be described in an example of flame mode confirmation control of a gas stove. Specifically, first, a flame mode (e.g., low flame mode) of the gas stove is selected by turning the magnetic control knob 100; then, the low flame mode of the gas stove is confirmed by pressing the top cover 1 of the magnetic control knob 100, so that the gas stove is controlled in a low flame state to cook the food.

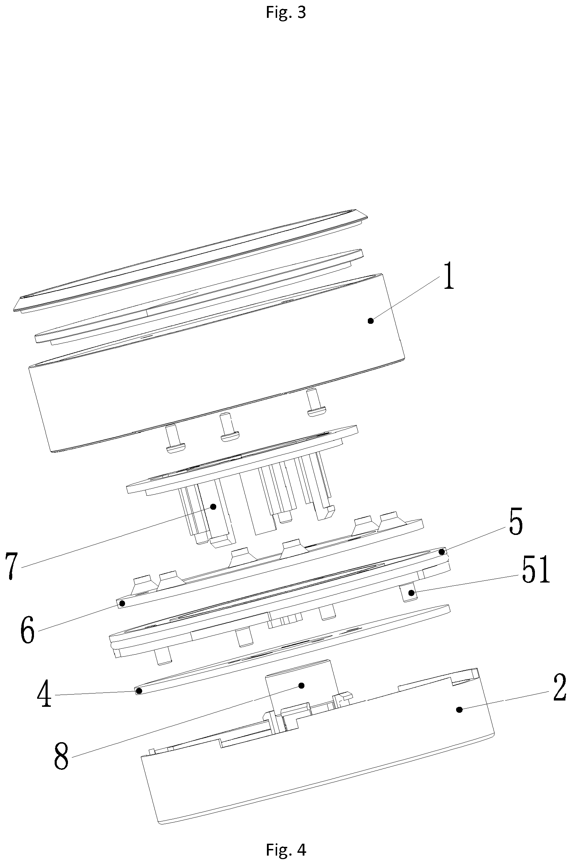

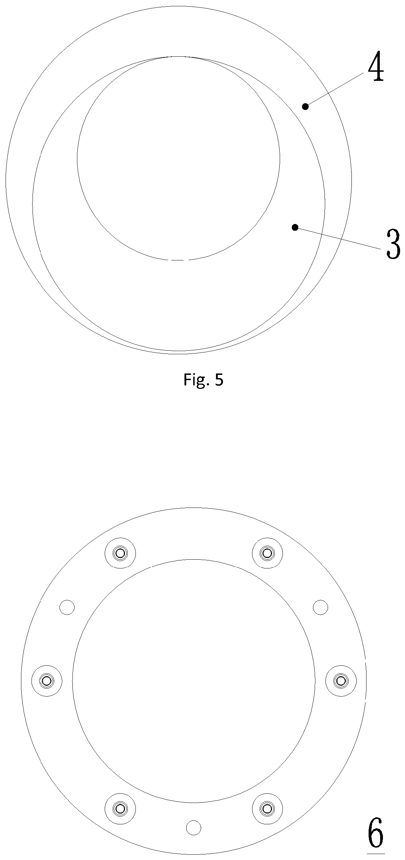

Particularly, the magnetic induction line cutter 3 is located in an inner cavity of knob X of the magnetic control knob 100, as shown in Figs. 2 and 3. Thus, damage to the magnetic induction line cutter 3 incurred by accidental touch in the assembling, transportation, or even user operation process of the magnetic control knob 100 can be prevented effectively, and thereby the service life of the magnetic control knob 100 or even the service life of the electrical apparatus can be improved. Furthermore, a bearing plate 4 is arranged in the inner cavity of knob X of the magnetic control knob 100 in a way that the bearing plate 4 is connected with the top cover 1 and arranged horizontally, and the magnetic induction line cutter 3 is a metal plate and superimposed on the surface of the bearing plate 4, as shown in Figs. 3-5. Thus, by superimposing the metal plate on the surface of the bearing plate 4, the reliability of the metal plate can be improved, and thereby the service life of the magnetic control knob 100 can be improved. Wherein, the magnetic induction line cutter 3 shall be made of a material that has high current conduction performance. For example, the magnetic induction line cutter 3 may be a copper plate or aluminum plate, or the like. Of course, alternatively the magnetic induction line cutter 3 may be made of other current-conducting materials, which are not enumerated here.

Specifically, the components arranged between the magnetic induction line cutter 3 and the energized conductors (e.g., bottom wall of the bottom cover 2, and casing 300 between the magnetic induction line cutter 3 and the energized conductors, etc.) shall be made of non-conducting materials, such as plastics, glass or ceramics, etc. It can be understood that the magnetic induction line cutter 3 doesn't cut the electromagnetic field of the energized conductors when it moves toward the bottom cover 2, i.e., the inductance of the energized conductors doesn't change, if the components arranged between the magnetic induction line cutter 3 and the energized conductors are made of materials with high current conduction performance.

Particularly, as shown in Fig. 1, the distance between the bottom end of the magnetic induction line cutter 3 and the top end of the energized conductors shall not be greater than 10mm. Furthermore, the distance between the bottom end of the magnetic induction line cutter 3 and the top end of the energized conductors shall not be greater than 9mm. Specifically, if the distance is greater than 10mm, a phenomenon that the inductance of the energized conductor doesn't change accordingly while the distance between the magnetic induction line cutter 3 and the energized conductors is changed, and consequently it is unable to trigger a signal to control the electrical apparatus, i.e., the pressing control function of the magnetic control knob 100 fails. Furthermore, a casing 300 is arranged between the magnetic control knob 100 and the conductor magnetic field generator, and usually the casing 300 is configured in 6mm thickness. Therefore, the distance between the bottom end of the magnetic induction line cutter 3 and the bottom surface of the bottom cover 2 preferably is not greater than 4mm; more preferably, the distance between the bottom end of the magnetic induction line cutter 3 and the bottom surface of the bottom cover 2 is not greater than 3mm.

Furthermore, the magnetic control knob 100 comprises an internal supporting member 5 arranged above the bearing plate 4 and fixedly arranged in the inner cavity of knob X horizontally, and an elastic resetting member for resetting by pressing is arranged between the top surface of the internal supporting member 5 and the bottom surface of the top cover 1, as shown in Figs. 2-4. Thus, when the user presses the top cover 1 of the magnetic control knob 100, the elastic resetting member will be deformed and store energy; after the user releases the pressing force, the elastic resetting member will release the elastic energy and drive the top cover 1 to reset automatically under the resilience force of the elastic resetting member.

Wherein, as shown in Figs. 3-6, the elastic resetting member is an annular silicone pad 6 abutting against the top surface of the internal supporting member 5 and the bottom surface of the top cover 1 respectively, and a plurality of upwardly recessed elastic resetting grooves 61 are arranged in the circumferential direction in a spaced form in the bottom surface of the annular silicone pad 6. Thus, the user enjoys a good pressing feeling when he/she presses the top cover 1, which is favorable for improving user experience; moreover, utilizing the annular silicone pad 6 as the elastic resetting member can effectively prevent seizing or jamming in the pressing process, and is helpful for improving the reliability of the magnetic control knob 100. Preferably, the elastic resetting grooves 61 are in a truncated cone shape, and an abutting boss protruding toward the internal supporting member is formed on the bottom surface of each groove. Thus, the user enjoys a good pressing feedback feeling in the pressing process, which brings good user experience. Of course, the elastic resetting member may be springs arranged in the circumferential direction of the internal supporting member 5 in a space manner, or the like, other than the annular silicone pad 6.

A plurality of connecting columns 7 may be arranged in the circumferential direction in a spaced form on the bottom surface of the top cover 1, and the bottom ends of the connecting columns 7 penetrate through the internal supporting member 5 downward from above and are snap-fitted to the bearing plate 4; a plurality of abutting columns 51 extend in the circumferential direction in a spaced form from the bottom surface of the internal supporting member 5, and the top surface of the bearing plate 4 abuts against the bottom surfaces of the abutting columns 51, as shown in Figs. 2-3. Thus, the bearing plate 4 can be retained, so that possible to-and-fro movement of the bearing plate 4 in the inner cavity of knob X in the process of transportation or movement of the magnetic control knob 100, which not only affects the user experience adversely but also causes damage to other components in the magnetic control knob 100, can be effectively prevented. Wherein, the connecting columns 7 may be integrally formed with the top cover 1, or may be connected with the top cover 1 via a connecting plate, as shown in Figs. 3 and 4. For example, a connecting plate may be arranged on the bottom surface of the top cover 1, and a plurality of connecting column 7 extending in the circumferential direction in a spaced form toward the bottom cover 2 may be arranged on the bottom surface of the connecting plate. However, the present invention is not limited to such an arrangement. Specifically, as shown in Figs. 1 and 2, the maximum distance of pressed movement of the top cover 1 toward the bottom cover 2 is not smaller than 0.8mm and not greater than 2.5mm. It can be understood: if the distance of pressed movement is too great, the pressing stroke will be long, causing compromised user experience; if the distance of pressed movement is too small, a phenomenon that the inductance of the energized conductors or other parameters (e.g., resonant frequency, etc.) induced by the inductance of the energized conductors can't be detected may occur, and consequently a signal can't be triggered to control the electrical apparatus accordingly. Wherein, to avoid triggering the control of the electrical apparatus incurred as a result of pressing the magnetic control knob 100 by mistake, preferably the distance is set to be close to the maximum distance of pressed movement of the top cover 1. For example, the distance may be set to be equal to or greater than 90% of the maximum distance of pressed movement, etc.

As shown in Fig. 1, the magnetic control knob assembly may comprise a fixed positioning magnet 202 that is arrange fixedly, the conductor magnetic field generator may comprise a plurality of solenoids 201 formed by energized conductors wound in multiple layers, and the plurality of solenoids 201 are arranged around the fixed positioning magnet 202. Furthermore, a knob positioning magnet 8 fitted with the fixed positioning magnet 202 is arranged at the center of the top surface of the bottom cover 2. Thus, by virtue of a magnetic attraction positioning effect between the fixed positioning magnets 202 and the knob positioning magnet 8, the magnetic control knob 100 not only can be moved away from the outer surface of the casing 300, but also can be placed by the user to an appropriate position conveniently, and thereby the user experience can be improved.

It should be noted specially that the other components and their functions of the magnetic control know assembly and electrical apparatus according to the embodiments of the present invention are well known to those having ordinary skilled in the art, and will not be detailed here to reduce redundancy.

In addition, it should be noted that the specific technical features described in above specific embodiments may be combined in any appropriate form, provided that there is no conflict among them. To avoid unnecessary repetition, various possible combinations are not described specifically in the present invention.

The scope of the invention is defined in the appended claims.

## Claims

1. A magnetic control knob assembly applied in an electrical apparatus, comprising:
A magnetic control knob (100) comprising both turning control function and pressing control function, comprising a top cover (1) and a bottom cover (2) that are snap-fitted with each other, wherein the top cover (1) is connected with a magnetic induction line cutter (3); and
comprising a conductor magnetic field generator;
wherein the top cover (1) can be pressed to move toward the bottom cover (2), the magnetic induction line cutter (3) cuts an electromagnetic field generated by the conductor magnetic field generator in the pressed movement process to change the inductance of energized conductors in the conductor magnetic field generator
**characterized in that** the conductor magnetic field generator is fixedly arranged in an inner cavity of a casing (300) of the electrical apparatus, and the magnetic control knob (100) is arranged on an outer surface of the casing (300) and can rotate freely.

2. The magnetic control knob assembly according to claim 1, wherein, a bearing plate (4) is arranged in an inner cavity of knob (X) of the magnetic control knob (100) in a way that the bearing plate (4) is connected with the top cover (1) and arranged horizontally, and the magnetic induction line cutter (3) is a metal plate and is superimposed on a surface of the bearing plate (4).

3. The magnetic control knob assembly according to claim 2, wherein, the distance between the bottom end of the magnetic induction line cutter (3) and the top end of the energized conductors is not greater than 10mm.

4. The magnetic control knob assembly according to claim 2, wherein, the magnetic control knob (100) comprises an internal supporting member (5) horizontally disposed above the bearing plate (4) and fixedly arranged in the inner cavity of knob (X), and an elastic resetting member (6) configured for resetting by pressing is arranged between an top surface of the internal supporting member (5) and an bottom surface of the top cover (1).

5. The magnetic control knob assembly according to claim 4, wherein, a plurality of connecting columns (7) are arranged in a circumferential direction in an interval arrangement on the bottom surface of the top cover (1), and bottom ends of the connecting columns (7) penetrate through the internal supporting member (5) downward from above and are snap-fitted to the bearing plate (4); a plurality of abutting columns (51) extend in a circumferential direction in an interval arrangement from the bottom surface of the internal supporting member (5), and a top surface of the bearing plate (4) abuts against bottom surfaces of the abutting columns (51).

6. The magnetic control knob assembly according to claim 4, wherein, the elastic resetting member (6) is an annular silicone pad (6) abutting against the top surface of the internal supporting member (5) and the bottom surface of the top cover (1) respectively, and a plurality of upwardly recessed elastic resetting grooves (61) are arranged in a circumferential direction in an interval arrangement in a bottom surface of the annular silicone pad (6).

7. The magnetic control knob assembly according to claim 1, wherein, the maximum distance of the pressed movement of the top cover (1) toward the bottom cover (2) is not smaller than 0.8mm and not greater than 2.5mm.

8. The magnetic control knob assembly according to any of claims 1-7, wherein, the conductor magnetic field generator comprises a capacitor and a solenoid (201) formed by an energized conductor wound in multiple layers, two ends of the solenoid (201) are connected with two ends of the capacitor through a first electrical connecting wire and a second electrical connecting wire, and a resonant frequency detector is arranged between the first electrical connecting wire and the second electrical connecting wire; the magnetic control knob assembly comprises a controller configured to:
Receive a resonant frequency signal from the resonant frequency detector;
Calculate the distance of movement of the magnetic induction line cutter (3) toward the solenoid (201) according to the resonant frequency signal; and
Trigger a control signal for the electrical apparatus if the distance of movement is greater than a preset distance.

9. The magnetic control knob assembly according to claim 8, wherein, the control signal is a device startup signal, a device shutdown signal, or a device operation acknowledgement signal.

10. The magnetic control knob assembly according to any of claims 1-7, wherein, the conductor magnetic field generator comprises a solenoid (201) formed by an energized conductor wound in multiple layers, and the magnetic control knob assembly comprises an inductance detector configured to detect the inductance of the solenoid (201) and a controller;
Wherein, the controller is configured to:
Receive an inductance signal from the inductance detector;
Calculate the distance of movement of the magnetic induction line cutter (3) toward the solenoid (201) according to the inductance signal; and
Trigger a control signal for the electrical apparatus if the distance of movement is greater than a preset distance.

11. The magnetic control knob assembly according to claim 1, comprising a fixed positioning magnet (202) arranged in a fixed manner, the conductor magnetic field generator comprises a plurality of solenoids (201), each of which is formed by an energized conductor wound in multiple layers, and the plurality of solenoids (201) are arranged around the fixed positioning magnet (202); and/or a knob positioning magnet (8) fitted with the fixed positioning magnet (202) is arranged at the center of the top surface of the bottom cover (2).

12. An electrical apparatus comprising a casing (300) and the magnetic control knob assembly according to any of claims 1-11, wherein, the conductor magnetic field generator is fixedly arranged in an inner cavity of the casing (300), and the magnetic control knob (100) is arranged on an outer surface of the casing (300) and can be rotated freely.

13. The electrical apparatus according to claim 12, wherein the electrical apparatus is a gas stove, a baking oven, an electromagnetic oven, a microwave oven, or a kitchen hood.

## Patentansprüche

1. Magnetische Steuerknopfanordnung, die in einer elektrischen Vorrichtung angewendet wird, umfassend:
einen magnetischen Steuerknopf (100), umfassend sowohl eine Drehsteuerfunktion als auch eine Drücksteuerfunktion, umfassend eine obere Abdeckung (1) und eine untere Abdeckung (2), die über eine Schnappmontage miteinander verbunden sind, wobei die obere Abdeckung (1) mit einem magnetischen Induktionsleitungsschneider (3) verbunden ist; und
umfassend einen Leitermagnetfeldgenerator;
wobei die obere Abdeckung (1) gedrückt werden kann, um sich in Richtung der unteren Abdeckung (2) zu bewegen, der magnetische Induktionsleitungsschneider (3) ein elektromagnetisches Feld schneidet, das vom Leitermagnetfeldgenerator während des Drückbewegungsprozesses erzeugt wird, um die Induktivität der erregten Leiter im Leitermagnetfeldgenerator zu ändern
**dadurch gekennzeichnet, dass** der Leitermagnetfeldgenerator fest in einem inneren Hohlraum des Gehäuses (300) der elektrischen Vorrichtung angeordnet ist, und der magnetische Steuerknopf (100) auf einer Außenfläche des Gehäuses (300) angeordnet ist und sich frei drehen kann.

2. Magnetische Steuerknopfanordnung gemäß Anspruch 1, wobei eine Lagerplatte (4) in einem inneren Hohlraum des Knopfes (X) des magnetischen Steuerknopfs (100) so angeordnet ist, dass die Lagerplatte (4) mit der oberen Abdeckung (1) verbunden und horizontal angeordnet ist, und der magnetische Induktionsleitungsschneider (3) eine Metallplatte ist und eine Oberfläche der Lagerplatte (4) überlagert.

3. Magnetische Steuerknopfanordnung gemäß Anspruch 2, wobei der Abstand zwischen dem unteren Ende des magnetischen Induktionsleitungsschneiders (3) und dem oberen Ende der erregten Leiter nicht größer als 10 mm ist.

4. Magnetische Steuerknopfanordnung gemäß Anspruch 2, wobei der magnetische Steuerknopf (100) ein internes Stützelement (5) umfasst, das horizontal über der Lagerplatte (4) angeordnet und fest in dem inneren Hohlraum des Knopfes (X) angeordnet ist, und ein elastisches Rückstellelement (6), das zum Zurücksetzen durch Drücken konfiguriert ist, zwischen einer Oberseite des inneren Stützelements (5) und einer Unterseite der oberen Abdeckung (1) angeordnet ist.

5. Magnetische Steuerknopfanordnung gemäß Anspruch 4, wobei eine Vielzahl von Verbindungssäulen (7) in Umfangsrichtung in einer Intervallanordnung auf der Unterseite der oberen Abdeckung (1) angeordnet sind, und die unteren Enden der Verbindungssäulen (7) von oben durch das innere Stützelement (5) nach unten eindringen und an der Lagerplatte (4) über eine Schnappmontage verbunden sind; eine Vielzahl von Stoßsäulen (51) sich in Umfangsrichtung in einer Intervallanordnung von der Unterseite des inneren Stützelements (5) erstrecken, und eine Oberseite der Lagerplatte (4) an Unterseiten der Stoßsäulen (51) anliegt.

6. Magnetische Steuerknopfanordnung gemäß Anspruch 4, wobei das elastische Rückstellelement (6) ein ringförmiges Silikonkissen (6) ist, das an der Oberseite des inneren Stützelements (5) bzw. der Unterseite der oberen Abdeckung (1) anliegt, und eine Vielzahl von nach oben vertieften elastischen Rückstellnuten (61) in einer Umfangsrichtung in einer Intervallanordnung in einer Unterseite des ringförmigen Silikonkissens (6) angeordnet ist.

7. Magnetische Steuerknopfanordnung gemäß Anspruch 1, wobei der maximale Abstand der Drückbewegung der oberen Abdeckung (1) zur unteren Abdeckung (2) nicht kleiner als 0,8 mm und nicht größer als 2,5 mm ist.

8. Magnetische Steuerknopfanordnung gemäß einem der Ansprüche 1 bis 7, wobei der Leitermagnetfeldgenerator einen Kondensator und einen Elektromagneten (201) umfasst, der durch einen in mehrere Schichten gewickelten erregten Leiter gebildet ist, wobei zwei Enden des Elektromagneten (201) mit zwei Enden des Kondensators durch einen ersten elektrischen Verbindungsdraht und einen zweiten elektrischen Verbindungsdraht verbunden sind, und ein Resonanzfrequenzdetektor zwischen dem ersten elektrischen Verbindungsdraht und dem zweiten elektrischen Verbindungsdraht angeordnet ist; die magnetische Steuerknopfanordnung eine Steuerung umfasst, die konfiguriert ist, um:
ein Resonanzfrequenzsignal vom Resonanzfrequenzdetektor zu empfangen;
den Bewegungsabstand des magnetischen Induktionsleitungsschneiders (3) zum Elektromagneten (201) gemäß dem Resonanzfrequenzsignal zu berechnen; und
ein Steuersignal für die elektrische Vorrichtung auszulösen, wenn der Bewegungsabstand größer als ein voreingestellter Abstand ist.

9. Magnetische Steuerknopfanordnung gemäß Anspruch 8, wobei das Steuersignal ein Gerätestartsignal, ein Geräteabschaltsignal oder ein Gerätebetriebsbestätigungssignal ist.

10. Magnetische Steuerknopfanordnung gemäß einem der Ansprüche 1 bis 7,
wobei der Leitermagnetfeldgenerator einen Elektromagneten (201) umfasst, der durch einen in mehrere Schichten gewickelten erregten Leiter gebildet ist, und die magnetische Steuerknopfanordnung einen Induktivitätsdetektor umfasst, der konfiguriert ist, die Induktivität des Elektromagneten (201) und einer Steuerung zu detektieren, wobei die Steuerung konfiguriert ist, um:
ein Induktivitätssignal vom Induktivitätsdetektor zu empfangen;
den Bewegungsabstand des magnetischen Induktionsleitungsschneiders (3) zum Elektromagneten (201) gemäß dem Induktivitätssignal zu berechnen. und
ein Steuersignal für die elektrische Vorrichtung auszulösen, wenn der Bewegungsabstand größer als ein voreingestellter Abstand ist.

11. Magnetische Steuerknopfanordnung gemäß Anspruch 1, umfassend einen fest angeordneten festen Positionierungsmagneten (202), wobei der Leitermagnetfeldgenerator eine Vielzahl von Elektromagneten (201) umfasst, von denen jeder durch einen in mehrere Schichten gewickelten erregten Leiter gebildet ist, und die Vielzahl von Elektromagneten (201) um den festen Positionierungsmagneten (202) angeordnet ist; und/oder ein Knopfpositioniermagnet (8), der mit dem festen Positioniermagneten (202) ausgestattet ist, in der Mitte der Oberseite der unteren Abdeckung (2) angeordnet ist.

12. Elektrische Vorrichtung, umfassend ein Gehäuse (300) und die magnetische Steuerknopfanordnung gemäß einem der Ansprüche 1 bis 11, wobei der Leitermagnetfeldgenerator fest in einem inneren Hohlraum des Gehäuses (300) angeordnet ist und der magnetische Steuerknopf (100) auf einer Außenfläche des Gehäuses (300) angeordnet ist und sich frei drehen kann.

13. Elektrische Vorrichtung gemäß Anspruch 12, wobei die elektrische Vorrichtung ein Gasherd, ein Backofen, ein elektromagnetischer Ofen, ein Mikrowellenofen oder eine Dunstabzugshaube ist.

## Revendications

1. Ensemble de bouton de commande magnétique utilisé dans un appareil électrique, comprenant :
un bouton de commande magnétique (100) comprenant à la fois une fonction de commande de rotation et une fonction de commande de pression, comprenant un couvercle supérieur (1) et un couvercle inférieur (2) encliquetés l'un dans l'autre, le couvercle supérieur (1) étant relié à un coupeur de ligne d'induction magnétique (3) ; et
comprenant un générateur de champ magnétique de conducteur;
dans lequel le couvercle supérieur (1) peut être pressé pour se déplacer vers le couvercle inférieur (2), le coupeur de ligne d'induction magnétique (3) coupe un champ électromagnétique généré par le générateur de champ magnétique de conducteur dans le processus de déplacement par pression pour modifier l'inductance de conducteurs sous tension dans le générateur de champ magnétique de conducteur,
**caractérisé en ce que** le générateur de champ magnétique de conducteur est disposé fixement dans une cavité intérieure d'un boîtier (300) de l'appareil électrique, et le bouton de commande magnétique (100) est disposé sur une surface extérieure du boîtier (300) et peut tourner librement.

2. Ensemble de bouton de commande magnétique selon la revendication 1, dans lequel une plaque d'appui (4) est disposée dans une cavité intérieure de bouton (X) du bouton de commande magnétique (100) de telle façon que la plaque d'appui (4) est reliée au couvercle supérieur (1) et disposée horizontalement, et le coupeur de ligne d'induction magnétique (3) est une plaque métallique et est superposé sur une surface de la plaque d'appui (4).

3. Ensemble de bouton de commande magnétique selon la revendication 2, dans lequel la distance entre l'extrémité inférieure du coupeur de ligne d'induction magnétique (3) et l'extrémité supérieure des conducteurs sous tension n'est pas plus grande que 10 mm.

4. Ensemble de bouton de commande magnétique selon la revendication 2, dans lequel le bouton de commande magnétique (100) comprend un élément de support intérieur (5) disposé horizontalement au-dessus de la plaque d'appui (4) et disposé fixement dans la cavité intérieure de bouton (X), et un élément de rappel élastique (6) configuré pour le rappel par pression est disposé entre une surface supérieure de l'élément de support intérieur (5) et une surface inférieure du couvercle supérieur (1).

5. Ensemble de bouton de commande magnétique selon la revendication 4, dans lequel une pluralité de colonnes de connexion (7) sont disposées dans une direction circonférentielle dans un agencement par intervalles sur la surface inférieure du couvercle supérieur (1), et des extrémités inférieures des colonnes de connexion (7) pénètrent à travers l'élément de support intérieur (5) vers le bas depuis le dessus et sont encliquetés dans la plaque d'appui (4) ; une pluralité de colonnes de butée (51) s'étendent dans une direction circonférentielle dans un arrangement par intervalles à partir de la surface inférieure de l'élément de support intérieur (5), et une surface supérieure de la plaque d'appui (4) bute contre des surfaces inférieures des colonnes de butée (51).

6. Ensemble de bouton de commande magnétique selon la revendication 4, dans lequel l'élément de rappel élastique (6) est un coussinet en silicone annulaire (6) butant contre la surface supérieure de l'élément de support intérieur (5) et la surface inférieure du couvercle supérieur (1) respectivement, et une pluralité de rainures de rappel élastiques (61) évidées vers le haut sont disposées dans une direction circonférentielle dans un arrangement par intervalles dans une surface inférieure du coussinet en silicone annulaire (6).

7. Ensemble de bouton de commande magnétique selon la revendication 1, dans lequel la distance maximale du déplacement par pression du couvercle supérieur (1) vers le couvercle inférieur (2) n'est pas plus petite que 0,8 mm et pas plus grande que 2,5 mm.

8. Ensemble de bouton de commande magnétique selon l'une quelconque des revendications 1 à 7, dans lequel le générateur de champ magnétique de conducteur comprend un condensateur et un solénoïde (201) formé par un conducteur sous tension enroulé en une multitude de couches, deux extrémités du solénoïde (201) sont reliées à deux extrémités du condensateur par le biais d'un premier fil de connexion électrique et d'un deuxième fil de connexion électrique, et un détecteur de fréquence résonnante est disposé entre le premier fil de connexion électrique et le deuxième fil de connexion électrique ; l'ensemble de bouton de commande magnétique comprend un dispositif de commande configuré pour :
recevoir un signal de fréquence résonnante provenant du détecteur de fréquence résonnante ;
calculer la distance de déplacement du coupeur de ligne d'induction magnétique (3) vers le solénoïde (201) en fonction du signal de fréquence résonnante ; et
déclencher un signal de commande pour l'appareil électrique si la distance de déplacement est supérieure à une distance prédéfinie.

9. Ensemble de bouton de commande magnétique selon la revendication 8, dans lequel le signal de commande est un signal de démarrage de dispositif, un signal d'arrêt de dispositif, ou un signal de reconnaissance de fonctionnement de dispositif.

10. Ensemble de bouton de commande magnétique selon l'une quelconque des revendications 1 à 7, dans lequel le générateur de champ magnétique de conducteur comprend un solénoïde (201) formé par un conducteur sous tension enroulé en une multitude de couches, et l'ensemble de bouton de commande magnétique comprend un détecteur d'inductance configuré pour détecter l'inductance du solénoïde (201) et un dispositif de commande ;
dans lequel le dispositif de commande est configuré pour :
recevoir un signal d'inductance provenant du détecteur d'inductance ;
calculer la distance de déplacement du coupeur de ligne d'induction magnétique (3) vers le solénoïde (201) en fonction du signal d'inductance ; et
déclencher un signal de commande pour l'appareil électrique si la distance de déplacement est supérieure à une distance prédéfinie.

11. Ensemble de bouton de commande magnétique selon la revendication 1, comprenant un aimant de positionnement fixe (202) disposé fixement, le générateur de champ magnétique de conducteur comprend une pluralité de solénoïdes (201), parmi lesquels chacun est formé par un conducteur sous tension enroulé en une multitude de couches, et la pluralité de solénoïdes (201) sont disposés autour de l'aimant de positionnement fixe (202) ; et/ou un aimant de positionnement de bouton (8) ajusté avec l'aimant de positionnement fixe (202) est disposé au centre de la surface supérieure du couvercle inférieur (2).

12. Appareil électrique comprenant un boîtier (300) et l'ensemble de bouton de commande magnétique selon l'une quelconque des revendications 1 à 11, dans lequel le générateur de champ magnétique de conducteur est disposé fixement dans une cavité intérieure du boîtier (300), et le bouton de commande magnétique (100) est disposé sur une surface extérieure du boîtier (300) et peut tourner librement.

13. Appareil électrique selon la revendication 12, dans lequel l'appareil électrique est une cuisinière à gaz, un four de cuisson, un four électromagnétique, un four à microondes ou une hotte de cuisine.
